# EUROPÄISCHE PATENTSCHRIFT

(11) **EP 1 391 030 B1**
(45) Veröffentlichungstag und Bekanntmachung des Hinweises auf die Patenterteilung: **13.10.2004**
(21) Anmeldenummer: 02745101.2
(22) Anmeldetag: 29.05.2002
(51) Int. Cl.: H03B 5/04, H03B 5/12

(54) **SPANNUNGSGESTEUERTE OSZILLATORSCHALTUNG**
VOLTAGE-CONTROLLED OSCILLATOR CIRCUIT
CIRCUIT OSCILLATEUR COMMANDE EN TENSION

(30) Priorität: 31.05.2001 DE 10126594
(43) Veröffentlichungstag der Anmeldung: 25.02.2004
(73) Patentinhaber: Infineon Technologies AG, 81669 München (DE)
(72) Erfinder: FEILKAS, Klaus-Jürgen, 81675 München (DE); GELTINGER, Hans, 83727 - Schliersee (DE); MOREIRA, Jose, Pedro, 80333 München (DE)
(74) Vertreter: Epping, Hermann, Fischer
(86) Internationale Anmeldenummer: PCT/DE2002/001994
(87) Internationale Veröffentlichungsnummer: WO 2002/097964

(56) Entgegenhaltungen:
- US-A- 4 378 534
- US-A- 5 600 279
- US-A- 5 714 915

## Beschreibung

Die vorliegende Erfindung betrifft eine spannungsgesteuerte Oszillatorschaltung.

Spannungsgesteuerte Oszillatoren oder Voltage Controlled Oscillators, VCOs, sind üblicherweise als LC-Oszillatoren aufgebaut. Dabei wird eine Sinusschwingung durch Entdämpfung des LC-Schwingkreises mit Hilfe eines Verstärkers erzeugt.

Als abstimmbares Bauelement ist üblicherweise die Kapazität vorgesehen, welche beispielsweise als Kapazitätsdiode ausgebildet sein kann.

Derartige spannungsgesteuerte Oszillatoren mit LC-Resonator sind zur Integration in integrierten Schaltkreisen geeignet und beispielsweise in Phasenregelschleifen, englisch: PLL, Phase Locked Loop, anwendbar.

In integrierten Schaltkreisen kann die Versorgungsspannung einzelner Schaltungsblöcke schwanken, da beispielsweise weitere Schaltungsblöcke, welche die gleiche Versorgungsspannungsquelle haben, an- oder abgeschaltet werden. Eine Schwankung der Versorgungsspannung verursacht jedoch eine Schwankung der Schwingfrequenz am Ausgang eines spannungsgesteuerten Oszillators, welche auch als Pushing-Effekt bezeichnet wird. Schwankungen in der Schwingfrequenz des Oszillators sind jedoch normalerweise unerwünscht, da nachgeordnete Schaltungsblöcke eingangsseitig bestimmte Genauigkeiten der Eingangsfrequenz erfordern.

Zudem können durch Schwankungen der Betriebstemperatur einer integrierten Oszillatorschaltung zusätzliche Frequenzabweichungen durch Drifteffekte verursacht werden. Dies erfordert jedoch einen höheren Abstimmbereich des Oszillators und ist deshalb ebenfalls unerwünscht.

Da Schwankungen der Oszillatorfrequenz oft durch Schwankungen der Amplitude des Oszillatorsignals bedingt sind, welche wiederum durch Schwankungen der Versorgungsspannung bedingt sind, ist es denkbar, die Amplitude des Oszillatorsignals mittels eines Amplitudenregelkreises zu stabilisieren. Hierdurch wird jedoch das Rauschen in der Schaltung in oft unzulässiger Weise erhöht. Ebenfalls wäre es denkbar, qualitativ hochwertigere Kapazitäten beziehungsweise abstimmbare Kapazitäten einzusetzen, deren Kapazitätswert geringere Empfindlichkeiten gegenüber Amplitudenschwankungen aufweisen. Bei monolithischer Integration der Oszillatorschaltung sind hierbei jedoch zum einen fertigungsbedingt und zum anderen aus Kostengründen Grenzen gesetzt.

Weiterhin könnte die Versorgungsspannung des Oszillators mit einem Spannungsregler bereitgestellt werden, vergleiche beispielsweise Tietze, Schenk: Halbleiter-Schaltungstechnik, 10. Auflage 1993, S. 543ff und das Patent US-A-5 600 279 (Mori kazuhiro), Figur 1. Eine derartig bereitgestellte geregelte Ausgangsspannung ist jedoch zumindest um eine Basis-Emitter-Spannung kleiner als die Eingangsspannung des Reglers. Zudem würde in die nachfolgende Schaltung ein unerwünschtes, zusätzliches Phasenrauschen eingebracht.

Wie bereits erläutert, kann einem temperaturbedingten Schwanken der Oszillatorfrequenz beziehungsweise einem Wegdriften der Oszillatorfrequenz dadurch begegnet werden, daß der Abstimmbereich des Oszillators erhöht wird. Hiermit sind jedoch ebenfalls Nachteile verbunden, beispielsweise eine Erhöhung der Toleranzen der VCO-Abstimmkonstanten K_{VCO}.

Aufgabe der vorliegenden Erfindung ist es, eine spannungsgesteuerte Oszillatorschaltung anzugeben, welche zur monolithischen Integration geeignet ist und welche mit geringem Aufwand eine Kompensation von spannungsschwankungsbedingten Abweichungen der Oszillatorfrequenz ermöglicht.

Erfindungsgemäß wird die Aufgabe gelöst durch eine spannungsgesteuerte Oszillatorschaltung, aufweisend
- einen LC-Resonator, umfassend eine Induktivität und eine erste spannungsgesteuerte Kapazität zum Einstellen einer Schwingfrequenz,
- einen Entdämpfungsverstärker zum Bereitstellen einer negativen Impedanz, der mit dem LC-Resonator gekoppelt ist,
- einen Versorgungsspannungsanschluß, der mit dem Entdämpfungsverstärker zum Zuführen einer Versorgungsspannung gekoppelt ist und
- eine zweite spannungsgesteuerte Kapazität, die parallel zur ersten spannungsgesteuerten Kapazität angeschlossen ist, mit einem Steueranschluß, der mit dem Versorgungsspannungsanschluß zum Zuführen einer von der Versorgungsspannung abgeleiteten Spannung gekoppelt ist.

Der Steueranschluß der zweiten spannungsgesteuerten Kapazität, die durch Zuführen einer Steuerspannung abstimmbar bezüglich ihres Kapazitätswerts ist, kann entweder mit einer von der Versorgungsspannung abgeleiteten Spannung oder von der Versorgungsspannung selbst angesteuert sein.

Die mit ihren Lastanschlüssen parallel geschalteten ersten und zweiten spannungsgesteuerten Kapazitäten mit der beschriebenen jeweiligen Ansteuerung der Kapazitätswerte ermöglichen in einfacher Weise eine Kompensation von Spannungsschwankungen und hierdurch ein Vermeiden von Schwankungen der Oszillator-Ausgangsfrequenz, da die Kapazität der zweiten spannungsgesteuerten Kapazität abnimmt, wenn die Versorgungsspannung des Oszillators zunimmt, so daß der Frequenzdrift kompensiert wird. Bei Zunahme der Versorgungsspannung nimmt zugleich die Frequenz des Oszillators ab, und umgekehrt. Die Steuerspannung wird der zweiten spannungsgesteuerten Kapazität kathodenseitig zugeführt, wenn die Kapazität als Varaktordiode ausgebildet ist.

Die einstellbaren Kapazitätswerte der zweiten spannungsgesteuerten Kapazität sind bevorzugt deutlich geringer als die einstellbaren Kapazitätswerte der ersten spannungsgesteuerten Kapazität.

Die beschriebene spannungsgesteuerte Oszillatorschaltung weist aufgrund der beschriebenen Kompensation gute Phasenrausch-Eigenschaften auf und kann zur weiteren Verbesserung der Rauscheigenschaften beispielsweise als Gegentakt-Oszillator aufgebaut sein. Hierdurch sind zudem höhere Leistungen und bessere Wirkungsgrade möglich.

Mit einer am Steueranschluß der ersten spannungsgesteuerten Kapazität zuführbaren Abstimmspannung ist wie bei VCOs üblich ein Abstimmen der Oszillatorfrequenz möglich.

In einer bevorzugten Ausführungsform der vorliegenden Erfindung ist der Steueranschluß der zweiten spannungsgesteuerten Kapazität über eine Spannungsquelle an den Versorgungsspannungsanschluß angeschlossen.

Die Spannungsquelle stellt eine Bias-Spannung zur Verfügung. Diese von der Spannungsquelle bereitgestellte Bias-Spannung kann dazu verwendet werden, die Oszillatorschaltung in einem geeigneteren Betriebsbereich, beispielsweise in einem gewünschten Arbeitspunkt, zu betreiben. Falls die eingesetzte Spannungsquelle eine temperaturabhängige Spannung liefert, so kann diese zur Temperaturkompensation des Oszillators verwendet werden. Diese Spannung hängt dabei zum einen von der Umgebungstemperatur der Schaltung und zum anderen von der Versorgungsspannung der Schaltung ab. Bei geeigneter Auslegung der Spannungsquelle ist bei vorliegender Oszillatorschaltung eine Kompensation temperaturbedingter Frequenzdrifts möglich. Die Temperaturkompensation folgt dabei folgendem Prinzip:

Wenn die Betriebstemperatur der Oszillatorschaltung ansteigt, steigt auch die Spannung, die von der Spannungsquelle bereitgestellt wird, an, so daß der Kapazitätswert der zweiten spannungsgesteuerten Kapazität abnimmt und damit dem Zunehmen des Kapazitätswerts der ersten spannungsgesteuerten Kapazität im LC-Resonator entgegenwirkt.

In einer weiteren, bevorzugten Ausführungsform der vorliegenden Erfindung ist die Spannungsquelle zum Anschluß des Steueranschlusses der zweiten spannungsgesteuerten Kapazität an den Versorgungsspannungsanschluß als Diode ausgebildet.

Anstelle einer Diode kann die Spannungsquelle auch mehrere, in Serie geschaltete Dioden, je nach Auslegung der Schaltung, umfassen.

Die Steuerspannung der zweiten spannungsgesteuerten Kapazität ist demnach die Versorgungsspannung minus einer oder mehrerer Diodenspannungen, je nach Auslegung. Diese Diodenspannung ist dabei temperaturabhängig und wirkt dadurch der Temperaturabhängigkeit der Oszillatorfrequenz entgegen.

In einer weiteren, bevorzugten Ausführungsform der vorliegenden Erfindung ist der Steueranschluß der zweiten spannungsgesteuerten Kapazität über einen als Diode geschalteten Transistor an den Versorgungsspannungsanschluß angeschlossen.

In integrierter Schaltungstechnik ist ein Transistor, bei dem zur Bildung einer Diode sein Steueranschluß mit einem seiner Lastanschlüsse kurzgeschlossen ist, in einfacher Weise integrierbar.

In einer weiteren, vorteilhaften Ausführungsform der vorliegenden Erfindung ist der Transistor ein Bipolar-Transistor. Mittels eines als Diode geschalteten und zwischen Versorgungsspannungsanschluß der Oszillatorschaltung und zweiter Kapazitätsdiode an deren Steueranschluß angeschlossenen Bipolar-Transistors ist eine besonders präzise Nachbildung des Temperaturverhaltens der Ausgangsfrequenz der Oszillatorschaltung und damit deren genaue Kompensation möglich.

In einer weiteren, bevorzugten Ausführungsform der vorliegenden Erfindung umfaßt der Entdämpfungsverstärker zwei kreuzgekoppelte Transistoren. Die beiden kreuzgekoppelten Transistoren ermöglichen eine Ausführung der Oszillatorschaltung als Gegentaktoszillator und werden hierfür abwechselnd leitend. Die Kreuzkopplung der Transistoren ist dadurch gegeben, daß je ein Steueranschluß eines Transistors mit je einem Lastanschluß eines anderen Transistors des Transistorpaares unmittelbar galvanisch, kapazitiv oder transformatorisch verbunden ist. Die jeweils freien Lastanschlüsse der beiden Transistoren sind unmittelbar miteinander und mit einer Stromquelle zur Versorgung des Entdämpfungsverstärkers verbunden. Die Stromquelle kann dabei bevorzugt mit dem Versorgungsspannungsanschluß verbunden sein. Die kreuzgekoppelten Lastanschlüsse sind bevorzugt mit dem ebenfalls in symmetrischer Schaltungstechnik aufgebauten LC-Resonator verbunden.

Die Transistoren sind bevorzugt als Feldeffekt-Transistoren ausgebildet und in MOS-Schaltungstechnik aufgebaut.

In einer weiteren, bevorzugten Ausführungsform der vorliegenden Erfindung umfassen erste und zweite spannungsgesteuerte Kapazität je zwei kathodenseitig unmittelbar miteinander verbundene Kapazitätsdioden. Der Verbindungsknoten der Kapazitätsdioden an ihren Kathodenanschlüssen ist dabei zugleich jeweils der Steueranschluß der ersten und zweiten spannungsgesteuerten Kapazität.

Zum Erzielen einer Parallelschaltung der ersten und zweiten spannungsgesteuerten Kapazitäten sind bei vorliegender bevorzugter Ausführung die Anodenanschlüsse der Kapazitätsdioden jeweils paarweise miteinander verbunden.

An den Kathodenanschlüssen der ersten spannungsgesteuerten Kapazität ist demnach die Steuerspannung oder Abstimmspannung der Oszillatorschaltung selbst und an den Kathodenanschlüssen der die zweite spannungsgesteuerte Kapazität bildenden Varaktoren ist die Versorgungsspannung beziehungsweise eine von der Versorgungsspannung abgeleitete Spannung einkoppelbar.

Weitere Einzelheiten der Erfindung sind Gegenstand der Unteransprüche.

Die Erfindung wird nachfolgend an mehreren Ausführungsbeispielen anhand der Zeichnungen näher erläutert.

Es zeigen:
- Figur 1: beispielhaft das Prinzip der erfindungsgemäßen spannungsgesteuerten Oszillatorschaltung anhand eines vereinfachten Blockschaltbilds,
- Figur 2: eine Weiterbildung der Schaltung gemäß Figur 1 mit Temperaturkompensation anhand eines Blockschaltbilds
- Figur 3: ein Ausführungsbeispiel der Oszillatorschaltung gemäß Figur 1 mit einem Parallel-LC-Resonator,
- Figur 4: ein Ausführungsbeispiel der Oszillatorschaltung gemäß Figur 2 mit einem Parallel-LC-Resonator,
- Figur 5: eine beispielhafte Ausführungsform einer Oszillatorschaltung gemäß Figur 1 mit einem Serien-LC-Resonator,
- Figur 6: eine beispielhafte Ausführungsform der Oszillatorschaltung gemäß Figur 2 mit einem Serien-LC-Resonator und
- Figur 7: ein Schaltbild einer beispielhaften Ausführungsform der Oszillatorschaltung in einer Weiterbildung gemäß Figur 4.

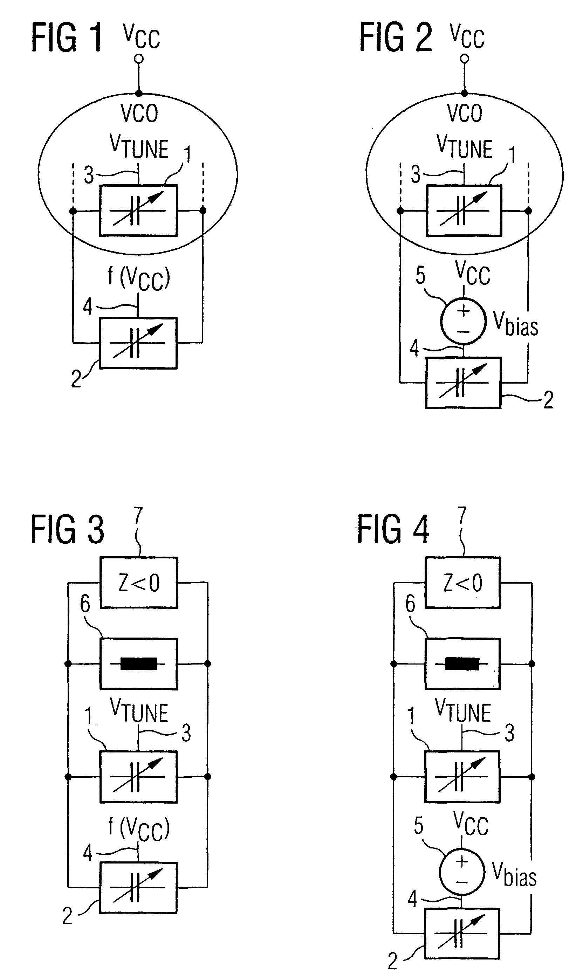

Figur 1 zeigt eine spannungsgesteuerte Oszillatorschaltung, aufweisend einen LC-Resonator mit einer ersten spannungsgesteuerten Kapazität 1, zu der eine zweite spannungsgesteuerte Kapazität 2 parallel geschaltet ist. Hierfür ist je ein Lastanschluß der ersten spannungsgesteuerten Kapazität 1 mit je einem Lastanschluß der zweiten spannungsgesteuerten Kapazität 2 unmittelbar verbunden. Erste und zweite spannungsgesteuerte Kapazitäten 1, 2 weisen jeweils einen Steueranschluß 3, 4 zum Einstellen ihres Kapazitätswerts auf. Dem Steueranschluß 3 der ersten spannungsgesteuerten Kapazität 1 ist eine Abstimmspannung V_{TUNE} zuführbar zum Einstellen einer Schwingfrequenz des Oszillators. Die spannungsgesteuerte Oszillatorschaltung ist zu ihrer Spannungsversorgung mit einem Versorgungsspannungsanschluß V_{CC} verbunden.

Der Steueranschluß 4 der zweiten spannungsgesteuerten Kapazität 2 ist mit dem Versorgungsspannungsanschluß V_{CC} zur Zuführung eines von der Versorgungsspannung abgeleiteten Signals gekoppelt.

Die Ableitung der Steuerspannung der zweiten spannungsgesteuerten Kapazität 2 aus der Versorgungsspannung V_{CC} der Oszillatorschaltung erfolgt dabei derart, daß versorgungsspannungsschwankungsbedingte Frequenzabweichungen der Oszillatorfrequenz kompensiert werden.

Figur 2 zeigt eine Weiterbildung der Oszillatorschaltung von Figur 1, welche gleiche Schaltungsteile mit gleichen Funktionen wie Figur 1 aufweist, die demnach hier nicht noch einmal wiederholt werden, die aber gegenüber der Schaltung von Figur 1 dahingehend weitergebildet ist, daß eine Spannungsquelle 5 vorgesehen ist, die mit einem Anschluß mit dem Versorgungsspannungsanschluß V_{CC} und mit ihrem anderen Anschluß mit dem Steuereingang 4 der zweiten spannungsgesteuerten Kapazität 2 verbunden ist. Die Spannungsquelle 5 stellt dabei am Steuereingang 4 eine Spannung bereit, welche temperaturabhängig und versorgungsspannungsabhängig ist und Frequenzdrifts am Ausgang der Oszillatorschaltung, welche temperaturbedingt sind, ausgleicht. Bei einem Oszillator, dessen Oszillatorfrequenz abnimmt, wenn die Versorgungsspannung V_{CC} zunimmt, nimmt demnach die Kapazität der zweiten spannungsgesteuerten Kapazität 2 ab, wenn die Versorgungsspannung V_{CC} zunimmt. Die von der Spannungsquelle 5 bereitgestellte Spannung nimmt hierfür mit zunehmender Temperatur zu, derart, daß temperaturbedingte Frequenzdrifts im Oszillator gerade kompensiert sind.

Figur 3 zeigt eine Weiterbildung der Oszillatorschaltung von Figur 1, bei der der LC-Resonator als Parallel-Resonator ausgeführt ist. Hierfür ist ein Entdämpfungsverstärker 7 parallel zu einer Induktivität 6 und parallel zur ersten spannungsgesteuerten Kapazität 1 angeschlossen. Diese drei Bauelemente bilden zusammen eine spannungsgesteuerte Oszillatorschaltung, welche durch Parallelschalten einer zweiten spannungsgesteuerten Kapazität 2 wie bereits erläutert bezüglich der Oszillatorfrequenz gegenüber Schwankungen der Versorgungsspannung stabilisiert ist.

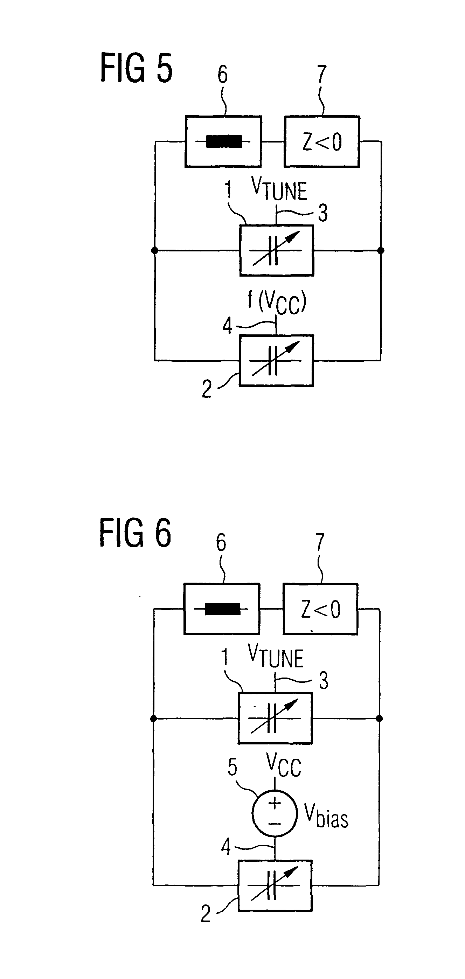

Figur 4 zeigt in Analogie zu Figur 3 eine Weiterbildung der Oszillatorschaltung von Figur 2 ebenfalls mit einem Parallel-LC-Resonator. Der Parallel-Resonator weist eine Parallelschaltung des Entdämpfungsverstärkers 7, der Induktivität 6 und der ersten spannungsgesteuerten Kapazität 1 auf, wie bereits für Figur 3 erläutert. Der Steuereingang 4 der zweiten spannungsgesteuerten Kapazität 2 ist über eine Spannungsquelle 5 an einen Versorgungsspannungsanschluß V_{CC} angeschlossen. Dieser stellt, wie bereits erläutert, eine Spannung am Steuereingang 4 der zweiten spannungsgesteuerten Kapazität 2 bereit, die temperaturbedingten und spannungsschwankungsbedingten Frequenzabweichungen des Oszillator entgegenwirkt.

Figur 5 zeigt in Form eines Blockschaltbildes eine Alternative zur Realisierung einer LC-Resonator-Schaltung gemäß Figur 3 und ebenfalls eine Weiterbildung des VCO gemäß Figur 1 mit einem LC-Serienschwingkreis. Hierbei sind erste spannungsgesteuerte Kapazität 1, Induktivität 6 und Entdämpfungsverstärker 7 zur Bereitstellung einer negativen Impedanz miteinander in einer Serienschaltung verschaltet. Eine zweite spannungsgesteuerte Kapazität 2 ist zur ersten spannungsgesteuerten Kapazität 1 und damit auch zu einer Serienschaltung aus Induktivität 6 und Entdämpfungsverstärker 7 parallel geschaltet. Die Funktion der Schaltung gemäß Figur 5 entspricht derjenigen von Figur 3 mit den genannten Vorteilen und soll an dieser Stelle nicht wiederholt werden.

Figur 6 zeigt in Alternative zum Blockschaltbild gemäß Figur 4 die Ausführung einer Oszillatorschaltung gemäß Figur 2, jedoch mit einem LC-Serienschwingkreis. Dabei ist eine Serienschaltung aus spannungsgesteuerter Kapazität 1, Induktivität 6 und Entdämpfungsverstärker 7 gebildet, wobei parallel zur ersten spannungsgesteuerten Kapazität 1 eine zweite spannungsgesteuerte Kapazität 2 angeschlossen ist. Der Steuereingang der zweiten spannungsgesteuerten Kapazität 2, der mit Bezugszeichen 4 versehen ist, ist über die Spannungsquelle 5 an den Versorgungspotentialanschluß V_{CC} angeschlossen. Die Schaltung gemäß Figur 6 entspricht in ihrer Funktion und ihren vorteilhaften Wirkungsweisen der in Figur 2 dargestellten Schaltung, diese sollen deshalb hier nicht noch einmal wiederholt werden.

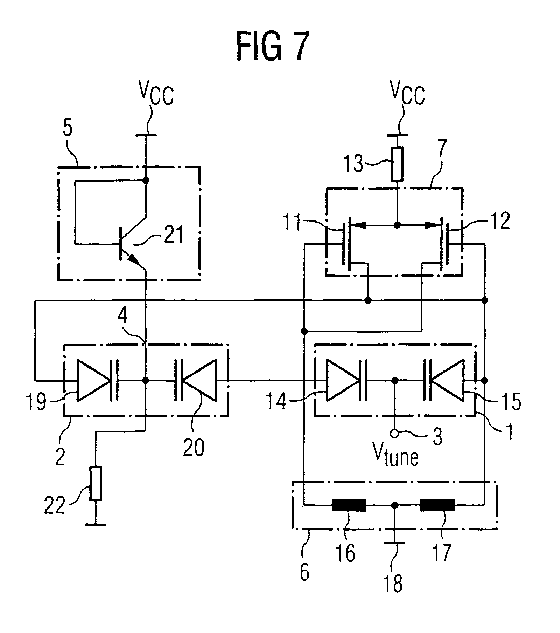

Figur 7 zeigt ein vereinfachtes Schaltbild eines als Gegentaktoszillator ausgeführten, spannungsgesteuerten Oszillators mit einer Kompensation der Oszillatorfrequenz bezüglich Betriebstemperatur und bezüglich Schwankungen der Versorgungsspannung V_{CC} in einer Weiterbildung gemäß Figur 2.

Im einzelnen umfaßt der Gegentaktoszillator eine Parallelschaltung aus erster spannungsgesteuerter Kapazität 1, Induktivität 6 und Entdämpfungsverstärker 7. Der Entdämpfungsverstärker 7 umfaßt dabei zwei Transistoren 11, 12, welche miteinander galvanisch kreuzgekoppelt sind. Die Transistoren 11, 12 sind als MOS-, Metal Oxide Semiconductor-Feldeffekttransistoren ausgebildet. Zur Bildung der galvanischen Kreuzkopplung ist der Gateanschluß des Transistors 11 mit dem Drainanschluß des Transistors 12 und umgekehrt der Gateanschluß des Transistors 12 mit dem Drainanschluß des Transistors 11 unmittelbar verbunden. Die Source-Anschlüsse der Transistoren 11, 12 sind unmittelbar miteinander und mit einer als Widerstand 13 ausgebildeten Stromquelle verbunden. Der Widerstand 13 ist mit einem weiteren Anschluß mit dem Versorgungsspannungsanschluß V_{CC} verbunden.

Die erste spannungsgesteuerte Kapazität 1 umfaßt zwei Varaktordioden 14, 15. Die Varaktordioden 14, 15 sind mit ihren Kathodenanschlüssen unmittelbar miteinander und mit dem Steueranschluß 3 der ersten spannungsgesteuerten Kapazität 1 verbunden. Je ein Anodenanschluß der Varaktoren 14, 15 ist mit je einem Gateanschluß der Transistoren 11, 12 verbunden.

Die Induktivität 6 umfaßt zwei Teil-Induktivitäten 16, 17, welche mit je einem Anschluß miteinander und mit einem Bezugspotentialanschluß 18 und mit je einem weiteren Anschluß mit je einem Anodenanschluß der Varaktoren 14, 15 verbunden sind.

Parallel zur ersten spannungsgesteuerten Kapazität 1 ist eine zweite spannungsgesteuerte Kapazität 2, umfassend ebenfalls zwei kathodenseitig unmittelbar miteinander verbundene Varaktoren 19, 20, angeschlossen. Hierfür sind die Anodenanschlüsse der Varaktoren 14, 20 und die Anodenanschlüsse der Varaktoren 15, 19 unmittelbar miteinander verbunden. Der Steueranschluß 4 der zweiten spannungsgesteuerten Kapazität 2 ist am gemeinsamen Kathodenanschluß der Varaktoren 19, 20 gebildet.

Zur Bildung einer Spannungsquelle 5 zwischen Versorgungspotentialanschluß V_{CC} und Steueranschluß 4 ist ein Bipolartransistor 21 vorgesehen, welcher als Diode geschaltet ist. Der Bipolar-Transistor 21 ist als npn-Transistor ausgebildet, dessen Kollektoranschluß mit seinem Basisanschluß unmittelbar und mit dem Bezugspotentialanschluß V_{CC} verbunden ist, und dessen Emitteranschluß mit dem Steueranschluß 4 der zweiten spannungsgesteuerten Kapazität 2 verbunden ist. Die Transistordiode 5 ist emitterseitig weiterhin über einen Strompfad, im vorliegenden Ausführungsbeispiel über einen Widerstand 22, an Bezugspotential angeschlossen.

Emitterseitig steht am Transistor 21 demnach eine Spannung bereit, welche zum einen vom Versorgungspotential V_{CC} und zum anderen von der Umgebungstemperatur abhängig ist und in Abhängigkeit von Temperatur und Versorgungsspannung V_{CC} den Kapazitätswert der zweiten spannungsgesteuerten Kapazität 2 steuert. Diese Ansteuerung ist dabei so ausgelegt, daß Schwankungen der Versorgungsspannung sowie Betriebstemperaturschwankungen, welche jeweils zu Schwankungen der Oszillatorfrequenz führen würden, gerade kompensiert sind.

Die vorliegende spannungsgesteuerte Oszillatorschaltung ermöglicht bei guten Rauscheigenschaften und ohne zusätzliche Erweiterung des Abstimmbereiches zum Ausgleich von Drifteffekten mit geringem schaltungstechnischem Aufwand eine Stabilisierung der Oszillatorfrequenz des spannungsgesteuerten Oszillators gegenüber Schwankungen der Versorgungsspannung und gegenüber Schwankungen der Betriebstemperatur der Schaltung.

### Bezugszeichenliste

- 1: spannungsgesteuerte Kapazität
- 2: spannungsgesteuerte Kapazität
- 3: Steueranschluß
- 4: Steueranschluß
- 5: Spannungsquelle
- 6: Induktivität
- 7: Entdämpfungsverstärker
- 11: MOS-FET
- 12: MOS-FET
- 13: Widerstand
- 14: Varaktor
- 15: Varaktor
- 16: Induktivität
- 17: Induktivität
- 18: Bezugspotentialanschluß
- 19: Varaktor
- 20: Varaktor
- 21: Bipolartransistor
- 22: Widerstand
- V_{TUNE}: Abstimmspannung
- V_{CC}: Versorgungsspannungsanschluß

## Patentansprüche

1. Spannungsgesteuerte Oszillatorschaltung, aufweisend
- einen LC-Resonator (1, 6), umfassend eine Induktivität (6) und eine erste spannungsgesteuerte Kapazität (1) zum Einstellen einer Schwingfrequenz,
- einen Entdämpfungsverstärker (7) zum Bereitstellen einer negativen Impedanz, der mit dem LC-Resonator (1, 6) gekoppelt ist,
- einen Versorgungsspannungsanschluß (V_{CC}), der mit dem Entdämpfungsverstärker (7) zum Zuführen einer Versorgungsspannung gekoppelt ist, **gekennzeichnet durch**
- eine zweite spannungsgesteuerte Kapazität (2), die parallel zur ersten spannungsgesteuerten Kapazität (1) angeschlossen ist, mit einem Steueranschluß (4), der mit dem Versorgungsspannungsanschluß (V_{CC}) zum Zuführen einer von der Versorgungsspannung abgeleiteten Spannung gekoppelt ist.

2. Oszillatorschaltung nach Anspruch 1,
**dadurch gekennzeichnet,daß**
der Steueranschluß (4) der zweiten spannungsgesteuerten Kapazität (2) über eine Spannungsquelle (5) an den Versorgungsspannungsanschluß angeschlossen ist.

3. Oszillatorschaltung nach Anspruch 1 oder 2,
**dadurch gekennzeichnet, daß**
der Steueranschluß (4) der zweiten spannungsgesteuerten Kapazität (2) über eine Diode (21) an den Versorgungsspannungsanschluß (V_{CC}) angeschlossen ist.

4. Oszillatorschaltung nach einem der Ansprüche 1 bis 3,
**dadurch gekennzeichnet, daß**
der Steueranschluß (4) der zweiten spannungsgesteuerten Kapazität (2) über einen als Diode geschalteten Transistor (21) an den Versorgungsspannungsanschluß (V_{CC}) angeschlossen ist.

5. Oszillatorschaltung nach Anspruch 4,
**dadurch gekennzeichnet, daß**
der Transistor (21) ein Bipolar-Transistor ist.

6. Oszillatorschaltung nach einem der Ansprüche 1 bis 5,
**dadurch gekennzeichnet, daß**
der Entdämpfungsverstärker (7) zwei kreuzgekoppelte Transistoren (11, 12) umfaßt.

7. Oszillatorschaltung nach einem der Ansprüche 1 bis 6,
**dadurch gekennzeichnet, daß**
erste und zweite spannungsgesteuerte Kapazität (1, 2) je zwei kathodenseitig miteinander verbundene Kapazitätsdioden (14, 15; 19, 20) umfassen.

## Claims

1. Voltage-controlled oscillator circuit, having
- an LC resonator (1, 6), comprising an inductance (6) and a first voltage-controlled capacitance (1) for setting an oscillation frequency,
- a deattenuation amplifier (7) for providing a negative impedance which is coupled to the LC resonator (1, 6),
- a supply voltage terminal (V_{CC}), which is coupled to the deattenuation amplifier (7) for feeding a supply voltage, **characterized by**
- a second voltage-controlled capacitance (2), which is connected in parallel with the first voltage-controlled capacitance (1), with a control terminal (4) coupled to the supply voltage terminal (V_{CC}) for feeding a voltage derived from the supply voltage.

2. Oscillator circuit according to Claim 1,
**characterized in that**
the control terminal (4) of the second voltage-controlled capacitance (2) is connected to the supply voltage terminal via a voltage source (5).

3. Oscillator circuit according to Claim 1 or 2,
**characterized in that**
the control terminal (4) of the second voltage-controlled capacitance (2) is connected to the supply voltage terminal (V_{CC}) via a diode (21).

4. Oscillator circuit according to one of Claims 1 to 3,
**characterized in that**
the control terminal (4) of the second voltage-controlled capacitance (2) is connected to the supply voltage terminal (V_{CC}) via a transistor (21) connected as a diode.

5. Oscillator circuit according to Claim 4,
**characterized in that**
the transistor (21) is a bipolar transistor.

6. Oscillator circuit according to one of Claims 1 to 5,
**characterized in that**
the deattenuation amplifier (7) comprises two cross-coupled transistors (11, 12).

7. Oscillator circuit according to one of Claims 1 to 6,
**characterized in that**
first and second voltage-controlled capacitances (1, 2) each comprise two variable-capacitance diodes (14, 15; 19, 20) connected to one another on the cathode side.

## Revendications

1. Circuit oscillant commandé en tension et comprenant
- un résonateur (1, 6) LC comportant une inductance (6) et une première capacité (1) commandée en tension pour établir une fréquence d'oscillation,
- un amplificateur (7) de régénération pour mettre à disposition une impédance négative, qui est couplé au résonateur (1, 6) LC,
- une borne V_{CC} de tension d'alimentation, qui est couplée à l'amplificateur (7) de régénération pour l'application d'une tension d'alimentation, **caractérisé par**
- une deuxième capacité (2) qui est commandée en tension, qui est montée en parallèle à la première capacité (1) commandée en tension et qui a une borne (4) de commande qui est couplée à la borne V_{CC} de tension d'alimentation pour appliquer une tension dérivée de la tension d'alimentation.

2. Circuit oscillant suivant la revendication 1,
**caractérisé en ce que**
la borne (4) de commande de la deuxième capacité (2) commandée en tension est reliée par une source (5) de tension à la borne de tension d'alimentation.

3. Circuit oscillant suivant la revendication 1 ou 2,
**caractérisé en ce que**
la borne (4) de commande de la deuxième capacité (2) commandée en tension est reliée par une diode (21) à la borne V_{CC} de tension d'alimentation.

4. Circuit oscillant suivant l'une des revendications 1 à 3,
**caractérisé en ce que**
la borne (4) de commande de la deuxième capacité (2) commandée en tension est reliée à la borne V_{CC} de tension d'alimentation par un transistor (21) monté en diode.

5. Circuit oscillant suivant la revendication 4,
**caractérisé en ce que**
le transistor (21) est un transistor bipolaire.

6. Circuit oscillant suivant l'une des revendications 1 à 5,
**caractérisé en ce que**
l'amplificateur (7) de régénération comprend deux transistors (11, 12) rétrocouplés.

7. Circuit oscillant suivant l'une des revendications 1 à 6,
**caractérisé en ce que**
la première et la deuxième capacités (1, 2) commandées en tension comprennent respectivement deux diodes (14, 15; 19, 20) à capacité variable reliées entre elles du côté de la cathode.
